# DEMANDE DE BREVET EUROPEEN

(11) **EP 1 753 112 A1**
(43) Date de publication de la demande: **14.02.2007**
(21) Numéro de dépôt: 06291269.6
(22) Date de dépôt: 04.08.2006
(51) Int. Cl.: H02J 7/00

(54) **Système et procédé de contrôle d'une batterie rechargeable**

(30) Priorité: 09.08.2005 FR 0508455
(71) Demandeur: SAFT, 93170 Bagnolet (FR)
(72) Inventeur: Morin, Christophe, 86530 Cenon s/Vienne (FR); Maloizel, Serge, 16730 Trois Palis (FR); Chanson, Claude, 16200 Jarnac (FR)
(74) Mandataire: Khairallah, Murielle

(57) **Abrégé**

Un système de contrôle d'une batterie rechargeable comportant au moins deux générateurs électrochimiques (2) raccordés électriquement par une ligne de puissance (3) comprend un organe de protection (11) et au moins deux organes de contrôle (10) respectivement connecté aux bornes de chaque générateur électrochimique. Chaque organe de contrôle est adapté à mesurer au moins un paramètre de fonctionnement propre audit générateur et à commander l'organe de protection par transmission de courants porteurs sur la ligne de puissance.

Le système de contrôle selon l'invention s'affranchit du calculateur maître pour la commande des organes de protection de la batterie et diminue les fils de connexion en supprimant les fils de mesure destinés à transmettre les mesures des paramètres de fonctionnement de chaque générateur au calculateur maître.

## Description

L'invention concerne le domaine des batteries rechargeables comprenant une pluralité de générateurs électrochimiques reliés entre eux en série et/ou en parallèle par une ligne de puissance. L'invention concerne plus particulièrement le domaine des systèmes de contrôle du fonctionnement de la batterie.

Les systèmes de contrôle peuvent contrôler l'état de charge et de décharge de la batterie, mais également la température et/ou le courant dans chaque générateur électrochimique. Chaque générateur électrochimique constitue un module indépendant qui peut être déchargé pour que la batterie fournisse l'énergie électrique nécessaire à une application donnée, par exemple un véhicule électrique. La batterie peut en outre être rechargée pour augmenter la capacité stockée dans chaque générateur électrochimique. Une ligne de puissance raccorde les générateurs entre eux et se termine par des bornes destinées à être raccordées à l'application.

La tension mesurée aux bornes d'une batterie peut être représentative de l'état de charge des générateurs électrochimiques (ou accumulateurs) qui constituent les modules de la batterie. L'état de charge des générateurs électrochimiques fait donc l'objet d'une surveillance permanente par des dispositifs de contrôle de tension. Plus précisément, ces dispositifs sont destinés à éviter que les générateurs électrochimiques ne fassent l'objet de surcharges ou de fortes décharges qui réduisent les performances de la batterie mais surtout en limitent la durée de vie.

Les documents EP-A-0 678 753, EP-A-0 855 780 et EP-A-1 018 652 décrivent des systèmes et procédés de contrôle d'un ensemble de générateurs électrochimiques comportant une logique commune et une pluralité d'interfaces de mesure associées à chaque générateur. La logique commune est intégrée dans un calculateur maître de la batterie recueillant les mesures provenant de chaque interface générateur agissant comme des parties esclaves. Le calculateur maître commande un ou des organes de protection selon les mesures fournies par les interfaces esclaves. Le calculateur maître représente un coût non négligeable du système de contrôle de la batterie. En effet, ce calculateur maître est généralement spécifique à chaque type de batterie (nombre et type de générateurs, paramètres de fonctionnement dépendant de l'application cible...).

En outre, les systèmes de contrôle décrits dans les documents précités nécessitent un câblage complexe et coûteux. Dans EP-A-1 018 652, une interface de mesure est individuellement associée à chaque générateur et une logique commune est prévue pour l'ensemble du système de contrôle. Les interfaces individuelles de mesure fournissent successivement leurs signaux de mesure par l'intermédiaire d'une première liaison série filaire. Les signaux de mesure sont transmis en réponse à des impulsions de sélection d'interface transmises en série d'une interface à l'autre par une seconde liaison filaire série. La quantité de fils de mesure est particulièrement importante et augmente les risques de dysfonctionnement du système.

Le document WO-A-2004/047215 propose de supprimer le câblage nécessaire aux transmissions des mesures entre les interfaces esclaves associées à chaque générateur et le calculateur maître en transmettant ces mesures par une liaison sans fil, en particulier par liaison radio. Ce document ne propose cependant pas de supprimer le calculateur maître. En outre, une liaison radio peut manquer de fiabilité et le système peut détecter avec retard des conditions de fonctionnement abusives si des interférences brouillent la liaison radio.

Par ailleurs, le document JP 11-318033 décrit un système de gestion centralisé pour batterie. Ce document propose également de supprimer les fils de connexion nécessaires aux transmissions des mesures entre les interfaces esclaves associées à chaque générateur et le calculateur maître en transmettant ces mesures par couplage sur la ligne de puissance. Ce document ne propose cependant pas de supprimer le calculateur maître.

Il existe donc un besoin pour un système de contrôle pour batterie qui soit simplifié et moins onéreux et en particulier pour un système de contrôle qui permette de supprimer le calculateur maître tout en limitant les fils de connexion destinés aux transmissions des mesures de paramètres de chaque générateur.

A cet effet, l'invention propose un système de contrôle d'une batterie rechargeable comportant au moins deux générateurs électrochimiques raccordés électriquement par une ligne de puissance, le système comprenant :
- un organe de protection ;
- au moins deux organes de contrôle respectivement connecté aux bornes de chaque générateur électrochimique, chaque organe de contrôle étant adapté à mesurer au moins un paramètre de fonctionnement propre audit générateur et à commander l'organe de protection par transmission de courants porteurs sur la ligne de puissance.

Selon une caractéristique, le système de contrôle selon l'invention ne comporte pas de calculateur maître de l'ensemble des paramètres de fonctionnement mesurés aux bornes de chaque générateur électrochimique.

Selon les modes de réalisation, le système de contrôle selon l'invention peut présenter une ou plusieurs des caractéristiques suivantes :
- le paramètre de fonctionnement mesuré par chaque organe de contrôle est choisi parmi la tension aux bornes du générateur et/ou la température dans le générateur et/ou le courant traversant le générateur ;
- chaque organe de contrôle comporte une unité électronique adaptée à comparer le paramètre mesuré avec un seuil prédéterminé et adaptée à commander la transmission d'un signal vers l'organe de protection lorsque ledit paramètre dépasse le seuil prédéterminé ;
- chaque organe de contrôle comporte un oscillateur de fréquence et un générateur de courant de manière à produire des impulsions de courants à haute fréquence transmises sur la ligne de puissance ;
- l'organe de protection commande un interrupteur inséré sur la ligne de puissance ;
- l'interrupteur est adapté à interrompre la charge et/ou la décharge de la batterie ;
- chaque organe de contrôle comporte un capteur de courant détectant un passage de courant dans la ligne de puissance et un interrupteur commandé par ledit capteur, chaque organe étant basculé en mode veille lorsque le courant dans la ligne de puissance est inférieur à une valeur prédéterminée ;
- en mode veille, l'organe de contrôle interrompt la mesure du paramètre de fonctionnement du générateur ;
- chaque l'organe de contrôle est adapté à détecter des conditions de fin de charge du générateur et à commander, localement, une dérivation de courant ;

L'invention concerne aussi une batterie rechargeable comportant au moins deux générateurs électrochimiques raccordées électriquement par une ligne de puissance, caractérisée en ce qu'elle comprend un système de contrôle selon l'invention.

Selon les modes de réalisation de la batterie de l'invention, chaque générateur électrochimique est choisi dans un groupe comprenant au moins les générateurs lithium/ion, les générateurs argent/zinc, les générateurs à polymères, les accumulateurs alcalins (Ni/Cd, Ni/MH) et les générateurs à technologie plomb.

L'invention propose aussi un procédé de contrôle de la tension d'une batterie comportant au moins deux générateurs électrochimiques raccordés électriquement par une ligne de puissance, le procédé comprenant les étapes de :
- mesure d'au moins un paramètre de fonctionnement propre à chaque générateur électrochimique par un organe de contrôle connecté aux bornes dudit générateur :

- détection de conditions de fonctionnement abusives par ledit organe de contrôle ;
- transmission d'un signal de commande d'arrêt de fonctionnement à un organe de protection de la batterie, comprenant les étapes d'émission, par ledit organe de contrôle, de courants porteurs sur la ligne de puissance et de réception desdits courants porteurs par l'organe de protection ;
- interruption de la charge et/ou de la décharge de la batterie par ledit organe de protection.

Selon les modes de réalisation le procédé de contrôle selon l'invention comprend en outre une ou plusieurs des caractéristiques suivantes :
- interruption de la charge et/ou de la décharge de la batterie par ledit organe de protection ;
- l'étape de mesure consiste à mesurer la tension aux bornes du générateur et/ou la température dans le générateur et/ou le courant traversant le générateur ;
- l'étape de détection de conditions de fonctionnement abusives comprend une étape de comparaison du paramètre de fonctionnement mesuré avec un seuil prédéterminé ;
- l'étape d'émission d'une commande d'arrêt de fonctionnement consiste à générer des impulsions de courant à haute fréquence et à envoyer ces impulsions sur la ligne de puissance ;

Selon une caractéristique, le procédé de contrôle selon l'invention comprend en outre les étapes suivantes :
- mesure du courant parcourant la ligne de puissance par chaque organe de contrôle ;
- mise en veille de l'organe de contrôle lorsque le courant mesuré est inférieur à une valeur prédéterminée.

D'autres caractéristiques et avantages de l'invention apparaîtront à la lecture de la description détaillée qui suit des modes de réalisation de l'invention, donnés à titre d'exemple uniquement et en références aux dessins qui montrent :
- figure 1 illustre de façon schématique un système de contrôle d'une batterie selon un premier mode de réalisation de l'invention;
- figure 2 illustre de façon schématique un système de contrôle d'une batterie selon un deuxième mode de réalisation de l'invention.

L'invention propose un système de contrôle d'une batterie rechargeable. Une telle batterie comporte une pluralité de générateurs électrochimiques raccordés électriquement entre eux par une ligne de puissance. Comme expliqué précédemment, on cherche à contrôler l'état de charge et de décharge de chaque générateur. A cet effet, le système de contrôle selon l'invention comprend un organe de contrôle connecté aux bornes de chaque générateur électrochimique et un organe de protection de la batterie. Chaque organe de contrôle est adapté à mesurer au moins un paramètre de fonctionnement propre au générateur auquel il est connecté et à commander directement l'organe de protection.

On a ainsi supprimé le calculateur maître puisque chaque organe de contrôle, associé à chaque générateur, non seulement mesure une valeur d'un paramètre de fonctionnement, généralement la tension aux bornes du générateur et/ou la température, mais commande également directement l'organe de protection en cas de détection de conditions de fonctionnement abusives. Les organes de contrôle constituent une pluralité de parties maître alors que l'organe de protection centralisé de la batterie est rendu esclave. Le câblage du système est aussi simplifié par la suppression des fils de mesures transmettant des mesures entre des interfaces générateurs et un calculateur maître inexistant.

En outre, selon une variante de l'invention, chaque organe de contrôle commande l'organe de protection par transmission de courants porteurs sur la ligne de puissance. Le câblage du système est ainsi encore simplifié puisque les signaux de commande de organes de protection ne sont pas transmis via des liaisons filaires dédiées mais par la ligne de puissance existante.

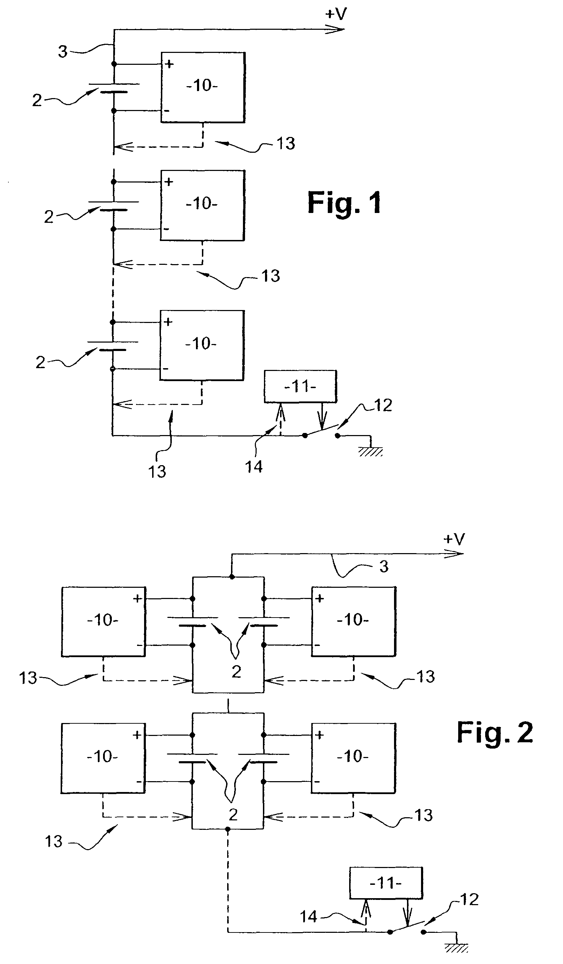

Les figures 1 et 2 illustrent le système selon l'invention. Sur la figure 1, tous les générateurs électrochimiques sont reliés en série par la ligne de puissance alors que sur la figure 2, les générateurs sont placés en parallèle deux par deux et les paires sont reliées en série par la ligne de puissance.

Les figures montrent une batterie comportant une pluralité de générateurs électrochimiques 2 raccordés par une ligne de puissance 3. La ligne de puissance 3 s'étend entre les bornes de polarité négative et positive de la batterie. Les figures montrent aussi une pluralité d'organes de contrôle 10 associés respectivement à chaque générateur 2. Un organe de contrôle 10 est ainsi connecté aux bornes positive et négative de chaque générateur et assure en local l'acquisition de paramètres de fonctionnement propres au générateur auquel il est associé. En particulier, l'organe de contrôle 10 peut mesurer la tension aux bornes du générateur 2 et/ou le courant traversant le générateur et/ou la température dans le générateur. A cet effet, l'organe de contrôle 10 peut présenter des fils de connectique avec des capteurs positionnés sur ou dans le générateur 2, en plus des deux brins de connexion aux bornes du générateur.

Chaque organe de contrôle 10 est ainsi adapté à mesurer un ensemble de paramètres de fonctionnement du générateur auquel il est associé. En outre, chaque organe de contrôle 10 est adapté à interpréter en local ces paramètres mesurés, en particulier pour détecter des conditions de fonctionnement abusives du générateur 2 tel qu'une surcharge ou une décharge excessive, une forte élévation de température pouvant conduire à une dégradation irréversible du générateur. A cet effet, chaque organe de contrôle 10 peut comporter une unité électronique qui compare le paramètre mesuré avec un seuil prédéterminé. Si ledit paramètre dépasse le seuil prédéterminé, l'organe de contrôle 10 détecte un dysfonctionnement du générateur 2 et pilote directement un organe de protection 11 de la batterie.

Sur les figures 1 et 2, l'organe de protection 11 de la batterie commande un interrupteur 12 placé sur la ligne de puissance 3 qui a pour fonction d'arrêter ou de modifier la charge et/ou la décharge de la batterie. L'organe de protection 11 peut être un interrupteur intelligent, par exemple du type Smart MOS, qui peut autoriser le passage du courant dans la ligne de puissance 3 dans un seul sens afin d'interdire soit la charge soit la décharge de la batterie ou qui peut interdire tout passage de courant dans la ligne de puissance 3. L'organe de protection 11 peut également intégrer des fonctions d'auto protection afin d'interrompre tout passage de courant dans la ligne de puissance en cas de court-circuit ou de sur-courant de la batterie. Ces fonctions d'auto protection ne sont pas liées à un calculateur mais sont déterminées par le choix et l'agencement des transistors utilisés pour fabriquer l'organe de protection 11.

L'organe de protection 11 agit sur commande d'au moins un des organes de contrôle 10 ; l'organe de protection 11 constitue donc une partie esclave, c'est-à-dire sans calculateur ni fonction propre de commande sur le fonctionnement de la batterie. Par contre, chaque organe de contrôle 10 constitue une partie maître, c'est-à-dire doté de moyens de commande agissant sur le fonctionnement de la batterie. Les organes de contrôle 10 ne constituent pas pour autant une pluralité de calculateurs maîtres tels que dans l'art antérieur. Les organes de contrôle 10 du système selon l'invention sont des organes de mesure en continu de paramètres de fonctionnement des générateurs mais ces mesures n'ont pas à être transmises vers un calculateur central pour y être interprétées parce que l'interprétation des mesures est faite localement dans l'organe de contrôle.

Le calculateur maître, coûteux et spécifique à chaque batterie, est donc supprimé au profit de la pluralité d'organes de contrôle 10. Les cartes électroniques constituant les organes de contrôle ne sont pas spécifiques à un certain type de batterie puisqu'elles sont destinées à être associées aux générateurs ; il n'est donc pas nécessaire de fabriquer une carte électronique par type de batterie mais simplement de dupliquer la même carte quel que soit le nombre de générateurs dans la batterie. Les coûts sont donc réduits par une production de masse indifférenciée des organes de contrôle.

Chaque organe de contrôle 10 est ainsi adapté à mesurer des paramètres de fonctionnement (tension, température, courant ou autre) spécifiques à un générateur donné 2 et à interpréter ces mesures afin de détecter des conditions de fonctionnement particulières. Ainsi, l'organe de contrôle 10 peut détecter des conditions de fin de charge du générateur et commander, localement, une dérivation de courant afin d'assurer une fonction d'équilibrage avec les autres générateurs. L'organe de contrôle peut aussi détecter des conditions de fonctionnement abusives, telle qu'une surcharge ou une décharge excessive, et commander alors l'émission d'un signal d'arrêt de fonctionnement de la batterie vers l'organe de protection 11.

Selon un mode de réalisation avantageux, chaque organe de contrôle 10 commande l'organe de protection 11 par transmission de courants porteurs sur la ligne de puissance 3. A cet effet, l'organe de contrôle peut comporter un oscillateur de fréquence et un générateur de courant afin de produire des impulsions de courants à haute fréquence, de l'ordre de 10 MHz par exemple. Ces impulsions sont codées, par exemple en associant des valeurs digitales '0' ou '1' à des amplitudes de courant seuils différentes A₀ ou A₁ pour une impulsion donnée. Ces impulsions de courant à haute fréquence sont alors transmises sur la ligne de puissance 3 par un couplage électrique 13. L'organe de protection 11 comporte des moyens de couplage électrique 14 avec la ligne de puissance 3 afin de recevoir ces impulsions de courant. Par exemple, les moyens de couplage électrique 13 et 14 peuvent être constitués d'un fil électrique relié à la ligne de puissance avec un filtre pour ne laisser passer que les impulsions de courants à haute fréquence.

Les impulsions de courant portant une information depuis un organe de contrôle 10 jusqu'à l'organe de protection 11 ne perturbent pas l'écoulement du courant de charge ou de décharge de la batterie qui se situe dans une gamme de fréquence largement inférieure - inférieure à 500kHz. L'utilisation de la ligne de puissance pour transmettre les commandes des organes de contrôle maîtres vers l'organe de protection esclave permet de simplifier encore le système de contrôle selon l'invention en supprimant les fils de connexion destinés aux mesures et commandes.

Par ailleurs, selon un mode de réalisation, chaque organe de contrôle 10 peut comporter des moyens de gestion d'un mode veille. En effet, les cartes électroniques des organes de contrôle consomment du courant, pris sur la batterie et donc déduit de la capacité de chaque générateur. Lorsque la batterie est stockée ou simplement non utilisée, il n'est pas nécessaire de contrôler le fonctionnement de chaque générateur puisque les conditions abusives ne peuvent se produire. Chaque organe de contrôle 10 peut donc détecter le passage de courant sur la ligne de puissance 3 et si aucun courant ne circule en déduire que les mesures des paramètres de fonctionnement du générateur 2 peuvent être interrompues. A cet effet, l'organe de contrôle 10 peut comporter un capteur de courant placé sur ou à proximité de la ligne de puissance 3, comme par exemple un capteur à effet Hall, une magnéto-résistance ou une résistance de très faible valeur insérée sur la ligne de puissance et réalisant une fonction dite de « shunt ».

L'organe de contrôle 10 comporte en outre un interrupteur de veille relié au capteur de courant ; lorsque le courant circulant dans la ligne de puissance 3 devient inférieur à une valeur prédéterminée, l'interrupteur de veille bascule les circuits de mesure de l'organe de contrôle dans un mode veille pour interrompre les mesures de paramètres de fonctionnement du générateur. Le capteur de courant reste néanmoins actif et lorsque le courant circulant dans la ligne de puissance 3 devient supérieur à une valeur prédéterminée, l'interrupteur de veille bascule les circuits de mesure de l'organe de contrôle pour réactiver les prises de mesures des paramètres de fonctionnement du générateur. La consommation électrique des organes de contrôle est ainsi optimisée et la capacité de la batterie conservée pour l'application à laquelle elle est destinée.

L'invention permet ainsi d'optimiser le coût de fabrication des batteries à générateurs électrochimiques en limitant le coût et la complexité du système de contrôle associé ; en particulier en supprimant le calculateur maître généralement associé à chaque type de batterie pour interpréter l'ensemble des mesures des paramètres de fonctionnement de chaque générateur. Cette optimisation du système de contrôle peut être utilisée sur tout type de batterie, quel que soit le couple électrochimique utilisé dans les générateurs. L'invention concerne donc tous les types de batteries quels que soient les générateurs utilisés ; générateurs lithium/ion, générateurs argent/zinc ou générateurs à polymères, accumulateurs alcalins (Ni/Cd, Ni/MH), générateurs à technologie plomb, etc. Cela permet des volumes de production plus importants et une rationalisation des coûts.

Bien entendu, la présente invention n'est pas limitée aux modes de réalisation décrits à titre d'exemple; ainsi, la transmission d'un signal de commande d'arrêt depuis un organe de contrôle vers l'organe de protection de la batterie peut être effectuée autrement que par transmission de courants porteurs sur la ligne de puissance, par exemple par liaison radio ou filaire, bien que l'utilisation de courants porteurs soit préférée pour les raisons de fiabilité et de simplification évoquées plus haut.

## Revendications

1. Système de contrôle d'une batterie rechargeable comportant au moins deux générateurs électrochimiques (2) raccordés électriquement par une ligne de puissance (3), le système comprenant :
- un organe de protection (11) ;
- au moins deux organes de contrôle (10) respectivement connecté aux bornes de chaque générateur électrochimique (2), chaque organe de contrôle étant adapté à mesurer au moins un paramètre de fonctionnement propre audit générateur et à commander l'organe de protection par transmission de courants porteurs sur la ligne de puissance.

2. Système selon la revendication 1, **caractérisé en ce que** le paramètre de fonctionnement mesuré par chaque organe de contrôle est choisi parmi la tension aux bornes de la générateur et/ou la température dans le générateur et/ou le courant traversant le générateur.

3. Système selon la revendication 1ou 2, **caractérisé en ce que** chaque organe de contrôle comporte une unité électronique adaptée à comparer le paramètre mesuré avec un seuil prédéterminé et adaptée à commander la transmission d'un signal vers l'organe de protection lorsque ledit paramètre dépasse le seuil prédéterminé.

4. Système selon l'une des revendications 1 à 3, **caractérisé en ce que** chaque organe de contrôle comporte un oscillateur de fréquence et un générateur de courant de manière à produire des impulsions de courants à haute fréquence transmises sur la ligne de puissance.

5. Système selon l'une des revendications 1 à 4, **caractérisé en ce que** l'organe de protection (11) commande un interrupteur (12) inséré sur la ligne de puissance (3).

6. Système selon la revendication 5, **caractérisé en ce que** l'interrupteur est adapté à interrompre la charge et/ou la décharge de la batterie.

7. Système selon l'une des revendications 1 à 6, **caractérisé en ce que** chaque organe de contrôle comporte un capteur de courant détectant un passage de courant dans la ligne de puissance et un interrupteur commandé par ledit capteur, chaque organe étant basculé en mode veille lorsque le courant dans la ligne de puissance est inférieur à une valeur prédéterminée.

8. Système selon la revendication 7, **caractérisé en ce que**, en mode veille, l'organe de contrôle interrompt la mesure du paramètre de fonctionnement du générateur.

9. Système selon l'une des revendications 1 à 8, **caractérisé en ce que** chaque l'organe de contrôle est adapté à détecter des conditions de fin de charge du générateur et à commander, localement, une dérivation de courant.

10. Système selon l'une des revendications 1 à 9, **caractérisé en ce qu'**il ne comporte pas de calculateur maître de l'ensemble des paramètres de fonctionnement mesurés aux bornes de chaque générateur électrochimique

11. Batterie rechargeable comportant au moins deux générateurs électrochimiques raccordées électriquement par une ligne de puissance, **caractérisée en ce qu'**elle comprend un système de contrôle selon l'une des revendications 1 à 10.

12. Batterie selon la revendication 11, **caractérisée en ce que** chaque générateur électrochimique est choisi dans un groupe comprenant au moins les générateurs lithium/ion, les générateurs argent/zinc, les générateurs à polymères, les accumulateurs alcalins (Ni/Cd, Ni/MH) et les générateurs à technologie plomb.

13. Procédé de contrôle de la tension d'une batterie comportant au moins deux générateurs électrochimiques raccordés électriquement par une ligne de puissance, le procédé comprenant les étapes de :
- mesure d'au moins un paramètre de fonctionnement propre à chaque générateur électrochimique par un organe de contrôle connecté aux bornes dudit générateur ;
- détection de conditions de fonctionnement abusives par ledit organe de contrôle ;
- transmission d'un signal de commande d'arrêt de fonctionnement à un organe de protection de la batterie, comprenant les étapes d'émission, par ledit organe de contrôle, de courants porteurs sur la ligne de puissance et de réception desdits courants porteurs par l'organe de protection;
- interruption de la charge et/ou de la décharge de la batterie par ledit organe de protection.

14. Procédé selon la revendication 13, **caractérisé en ce que** l'étape de mesure consiste à mesurer la tension aux bornes du générateur et/ou la température dans le générateur et/ou le courant traversant le générateur.

15. Procédé selon la revendication 13 ou 14, **caractérisé en ce que** l'étape de détection de conditions de fonctionnement abusives comprend une étape de comparaison du paramètre de fonctionnement mesuré avec un seuil prédéterminé.

16. Procédé selon la revendication 15, **caractérisé en ce que** l'étape d'émission d'une commande d'arrêt de fonctionnement consiste à générer des impulsions de courant à haute fréquence et à envoyer ces impulsions sur la ligne de puissance.

17. Procédé selon l'une des revendications 13 à 16, **caractérisé en ce qu'**il comprend en outre les étapes suivantes :
- mesure du courant parcourant la ligne de puissance par chaque organe de contrôle ;
- mise en veille de l'organe de contrôle lorsque le courant mesuré est inférieur à une valeur prédéterminée.
